# EUROPÄISCHE PATENTSCHRIFT

(11) **EP 0 454 013 B1**
(45) Veröffentlichungstag und Bekanntmachung des Hinweises auf die Patenterteilung: **15.02.1995**
(21) Anmeldenummer: 91106413.7
(22) Anmeldetag: 22.04.1991
(51) Int. Cl.: G01R 1/36, G01R 19/165, G01R 19/145

(54) **Messschaltung zur Erfassung eines Stromes**
Measurement circuit for detecting a current
Circuit de mesure pour détecter un courant

(30) Priorität: 27.04.1990 DE 4013488
(43) Veröffentlichungstag der Anmeldung: 30.10.1991
(73) Patentinhaber: Gossen- Metrawatt GmbH, D-8500 Nürnberg (DE)
(72) Erfinder: Ziegler, Herbert, W-8500 Nürnberg (DE); Kindermann, Robert, W-8500 Nürnberg (DE)
(74) Vertreter: Hafner, Dieter, Dr.rer.nat., Dipl.-Phys.

(56) Entgegenhaltungen:
- EP-A- 0 035 808
- EP-A- 0 362 745
- TELECOMMUNICATIONS AND RADIO ENGINEERING. Bd. 44, Nr. 10, Oktober 1989,WASHINGTON US Seiten 175 - 177; MAKAROV: 'AN OVERLOAD PROTECTION DEVICE...'

## Beschreibung

### Meßschaltung zur Erfassung eines Stromes

Die Erfindung betrifft eine Meßschaltung der im Oberbegriff des Anspruchs 1 genannten Art.

Nach der Unfallverhütungsvorschrift "Elektrische Anlagen und Betriebsmittel" (VBG 4) muß bei allen Geräten und Betriebsmitteln der Schutzklasse II in bestimmten Zeitabständen eine Wiederholprüfung bzw. nach einer Reparatur eine Instandsetzungsprüfung durchgeführt werden. Hierbei ist der zwischen berührbaren leitfähigen Teilen des zu überprüfenden Objektes und Erde bzw. einem Schutzleiter fließende Ableitstrom zu messen. Nach den detaillierten Ausführungsbestimmungen (DIN VDE 0701 T 240) darf der zwischen den berührbaren leitfähigen Teilen und z.B. dem Schutzkontakt einer Steckdose fließende Ableitstrom einen vogegebenen Wert (z.B. 0,25 mA) nicht überschreiten. Der Innenwiderstand der Meßschaltung mit der die Strommessung erfolgt, soll maximal 2 kOhm betragen.

Führt man diese Messung mit einem üblichen Strommesser durch, so kann es, falls eine niederohmige Verbindung des zu prüfenden berührbaren Teiles mit einem Phasenleiter des Wechselspannungsnetzes besteht, zur Zerstörung des Meßgerätes kommen. Sofern jedoch das Meßgerät durch eine Schmelzsicherung vor Beschädigung geschützt ist, wird diese ansprechen und den Stromkreis unterbrechen. Eine solche Stromkeisunterbrechung birgt jedoch die Gefahr, daß die bedienende Person aus der fehlenden Anzeige auf das Fehlen eines Ableitstromes schließt. Eine sich daran anschließende vermeintlich risikolose Berührung des an Netzspannung liegenden Teiles kann schwerwiegende Folgen haben.

Die EP-A-0 035 808 zeigt eine aktive Strommeßanordnung mit Operationsverstärker und PTC.

Aufgabe der Erfindung ist es deshalb, eine Meßschaltung nach dem Oberbegriff des Anspruchs 1 zu schaffen, die bei einem unzulässig hohen, von der Meßschaltung erfaßten Strom, zu einem deutlich überhöhten Anzeigewert führt, ohne daß das Meßgerät hierbei gefährdet wird.

Diese Aufgabe wird durch die im Anspruch 1 gekennzeichneten Merkmale gelöst. Zweckmäßige Ausgestaltungen und Weiterbildungen des Erfindungsgegenstandes sind in den Unteransprüchen genannt.

Eine Schmelzsicherung ist ein Strombegrenzungselement, das im Fehlerfall den Stromkreis unterbricht und somit den Strom auf Null herabsetzt. Mit Hilfe eines das Strombegrenzungselement überbrückenden Stromnebenzweiges gelingt es erfindungsgemäß dem Eingang einer Meßvorrichtung auch dann noch einen Strom zuzuführen, wenn der eigentliche Meßkreis unterbrochen ist. Damit im Normalfall kein das Meßergebnis verfälschender Strom über den Stromnebenzweig fließt, darf dieser erst im Fehlerfall eingeschaltet werden. Dies geschieht mit Hilfe eines Grenzwertelementes, das erst dann aktiviert wird, wenn seine Grenzwertspannung überschritten wird, was wiederum auf den Fehlerfall beschränkt ist. Das nunmehr erzeugte Signal sorgt dafür, daß die Anzeige der Meßvorrichtung in den Überlauf geht, wodurch deutlich ein zu hoher Strom signalisiert wird.

Der von der Meßschaltung aufgenommene Strom muß über einen Shunt geleitet werden, damit ein von der Meßvorrichtung verarbeitbares Signal entsteht. Im Meßkreis ist somit ein erster Shunt und im Stromnebenzweig ein zweiter Shunt vorgesehen. Eine besonders zweckmäßige Ausgestaltung der Erfindung sieht nun vor, daß der erste Shunt mit dem zweiten Shunt eine am Eingang der Meßvorrichtung liegende Reihenschaltung bildet. Im Normalfall ist der zweite Shunt stromlos und liegt somit bei der Messung des durch den Meßstrom am ersten Shunt erzeugten Spannungsabfalls in Reihe zu dem wesentlich hochohmigeren Eingangswiderstand der Meßvorrichtung, so daß er auf die Messung ohne Einfluß bleibt. Im Fehlerfall dagegen erzeugt der vom Stromnebenzweig aufgenommene Strom an der Reihenschaltung des ersten mit dem zweiten Shunt ein dem Eingang der Meßvorrichtung zugeführtes Signal, das so groß ist, daß der Überlauf erreicht wird.

Für das Einschalten des Stomnebenzweiges mit Hilfe von Grenzwertelementen sind viele Lösungen denkbar. Eine besonders einfache Lösung sieht vor zwei gegenpolig geschaltete Zenerdioden zu verwenden, die mit einem in Reihe geschalteten Vorwiderstand und dem zweiten Shunt den Stromnebenzweig bilden.

Eine besonders vorteilhafte Weiterbildung des Erfindungsgegenstandes verwendet als Strombegrenzungselement einen PTC-Widerstand. Dieser begrenzt im Fehlerfall den Eingangsstrom der Meßschaltung bei entsprechender Dimensionierung auf Werte unter 1 mA. Der hierdurch erzeugte Spannungsabfall würde einen zulässigen Meßstrom vortäuschen, so daß die erfindungsgemäße, durch den Stromnebenzweig erreichte Anzeigeüberlaufsteuerung erhöhte Bedeutung erlangt. Ein wesentlicher Vorteil des PTC-Widerstandes gegenüber einer Schmelzsicherung ist im übrigen der Umstand, daß er seine Schutzwirkung behält und nach Beseitigung des Fehlerfalls wieder seinen Anfangswiderstand annimmt. Dadurch entfällt der Austausch eines beschädigten Bauelementes (Sicherung) und seine Vorratshaltung, die zur Gewährleistung der Betriebsbereitschaft des Meßgerätes andernfalls erforderlich wäre.

Um Toleranzen des PTC-Widerstandes in ihrer Auswirkung auf das Meßergebnis zu vermindern, ist es zweckmäßig einen entsprechend größeren Ergänzungswiderstand in Reihe zu schalten.

Durch eine geeignete Dimensionierung des zweiten Shunts, der vorzugsweise um den Faktor 10 bis 20 größer ausgelegt wird als der erste Shunt, gelingt es auch mit relativ kleinem Strom im Stromnebenzweig das Meßgerät in den Anzeigeüberlaufbereich zu steuern.

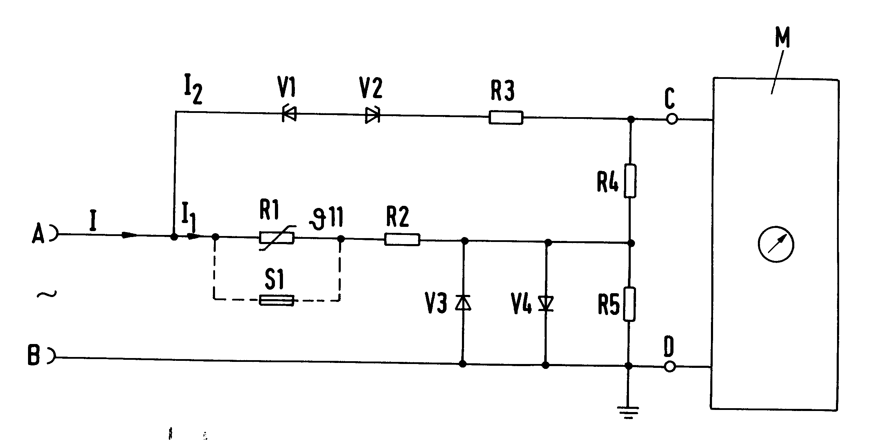

Ein Ausführungsbeispiel der Erfindung ist in der Zeichnung dargestellt und wird im folgenden näher beschrieben.

Wie die in der Zeichnung dargestellte Schaltungsanordnung erkennen läßt, liegt am Eingang C,D einer Meßvorrichtung M eine Reihenschaltung von zwei Widerständen R4,R5. Einer der beiden Widerstände bildet einen ersten Shunt R5 in einem Meßstromkreis R1(S1),R2,V3,V4,R5, der an einen Meßeingang A,B gelegt ist. Der andere der beiden Widerstände bildet in einem Stromnebenzweig V1,V2,R3,R4 einen zweiten Shunt R4.

Der Meßstromkreis besteht aus der Reihenschaltung eines PTC-Widerstandes R1, eines Ergänzungswiderstandes R2, und des ersten Shunts R5, der durch zwei antiparallel geschaltete Dioden V3,V4 überbrückt ist. Der PTC-Widerstand R1 kann dabei auch durch eine Schmelzsicherung oder eine andere Art den Stromkreis unterbrechender Sicherung ersetzt werden.

Der Stromnebenzweig ist aus der Reihenschaltung von zwei gegenpolig geschalteten Zenerdioden V1,V2, einem Vorwiderstand R3 und dem zweiten Shunt R4 gebildet. Er überbrückt den PTC-Widerstand R1 mit dem nachgeschalteten Ergänzungswiderstand R2.

Bei der Messung eines zulässigen, innerhalb des Meßbereiches liegenden Ableitstromes I fließt dieser über den relativ niederohmigen PTC-Widerstand R1 und den Ergänzungswiderstand R2 zum ersten Shunt R5, an dem er einen Spannungsabfall erzeugt, der über den zweiten Shunt R4 dem Eingang C,D der Meßvorrichtung M zur Auswertung zugeführt ist. Der erste Shunt R5 ist so dimensioniert, daß der an ihm erzeugte Spannungsabfall niedriger als die Schwellwertspannung der beiden Dioden V3,V4 ist.

Wird der Meßbereich und damit auch die Schwellwertspannung der Dioden V3,V4 überschritten, so werden diese leitend und schützen durch Übernahme des Ableitstromes I den parallelliegenden ersten Shunt R5. Bei erhöhter Überlast kippt der PTC-Widerstand in seinen hochohmigen Zustand und sorgt dafür, daß vom aufgenommenen Ableitstrom I nur ein reduzierter Meßkreisstrom I1 aufgenommen wird. Der auf einen Wert unter 1 mA verminderte Meßkreisstrom liegt innerhalb des normalen Meßbereiches und würde dadurch einen zulässigen Ableitstrom vortäuschen. Dem beugt jedoch der Stromnebenzweig mit Hilfe der beiden Zenerdioden V1,V2 vor, die durch den erhöhten Spannungsabfall am PTC-Widerstand R1 ansprechen und nun einen Nebenkreisstrom I2 über den Vorwiderstand R3 und die beiden Shunts R4,R5 leiten. Der Vorwiderstand R3 ist hochohmig und für die maximale Überlast dimensioniert. Der Gesamtwiderstand aus der Reihenschaltung der beiden Shunts R4,R5 ist so festgelegt, daß der an ihm erzeugte Spannungsabfall den Meßbereichsendwert deutlich überschreitet und dadurch einen Fehlerfall signalisiert. Es ist zweckmäßig den Widerstandswert des zweiten Shunts R4 um einen Faktor 10 bis 20 größer zu dimensionieren als den des ersten Shunts R5.

## Patentansprüche

1. Meßschaltung zur Erfassung eines Stromes, vorzugsweise des Ableitstromes bei der Überprüfung berührbarer Metallteile von Elektrogeräten, mit einem Meßeingang, der zum Schutz vor gefährlichen Fehlerspannungen durch Schwellwertelemente, vorzugsweise zwei antiparallel geschaltete Dioden (V3,V4), in Verbindung mit mindestens einem weiteren in Reihe liegenden Strombegrenzungselement (R1,S1), das im Fehlerfall den Eingangsstrom (I) begrenzt, überbrückt ist, und mit einem in Reihe zu dem Strombegrenzungselement geschalteten Shunt (R5), an dem ein dem Eingangsstrom entsprechender Spannungsabfall erzeugt wird, der als Meßsignal dem Eingang (C,D) einer Meßvorrichtung (M) zugeführt ist, dadurch gekennzeichnet, daß ein das Strombegrenzungselement (R1,S1) überbrückender Stromnebenzweig (V1,V2,R3,R4) gebildet ist, der durch mindestens ein Grenzwertelement (V1,V2) in einen leitenden Zustand versetzt wird, sobald im Fehlerfall das Strombegrenzungselement (R1,S1) anspricht und an ihm eine dem Grenzwert des Grenzwertelementes (V1,V2) entsprechende Spannung anliegt, und der dann im Strommnebenzweig (V1,V2,R3,R4) fließende Strom (I2) einen an einem zweiten Shunt (R4) abfallenden, dem Eingang (C,D) der Meßvorrichtung (M) zugeführten Spannungsabfall erzeugt, und das nunmehr am Eingang (C,D) anliegende Signal größer als das im Normalfall am ersten Shunt (R5) erzeugte, dem Meßbereichsendwert entsprechende Meßsignal ist.

2. Meßschaltung nach Anspruch 1, dadurch gekennzeichnet, daß der zweite Shunt (R4) mit dem ersten Shunt (R5) eine am Eingang der Meßvorrichtung (M) liegende Reihenschaltung bildet.

3. Meßschaltung nach einem der vorhergehenden Ansprüche, dadurch gekennzeichnet, daß als Grenzwertelement zwei gegenpolig geschaltete Zenerdioden (V1,V2) dienen, die mit einem in Reihe geschalteten Vorwiderstand (R3) und dem zweiten Shunt (R4) den Stromnebenzweig (V1,V2,R3,R4) bilden.

4. Meßschaltung nach einem der vorhergehenden Ansprüche, dadurch gekennzeichnet, daß in den Meßstromkreis zwischen das Strombegrenzungselement (R1,S1) und den ersten Shunt ein Ergänzungswiderstand (R2) geschaltet ist.

5. Meßschaltung nach einem der vorhergehenden Ansprüche, dadurch gekennzeichnet, daß als Strombegrenzungselement eine Schmelzsicherung (S1) dient.

6. Meßschaltung nach einem der vorhergehenden Ansprüche, dadurch gekennzeichnet, daß als Strombegrenzungselement ein PTC- Widerstand (R1) dient.

7. Meßschaltung nach einem der vorhergehenden Ansprüche, dadurch gekennzeichet, daß der Widerstandswert des zweiten Shunts (R4) wesentlich hochohmiger dimensioniert ist als der Widerstandswert des ersten Shunts (R5), vorzugsweise um den Faktor 10 bis 20 größer.

## Claims

1. Measurement circuit for determining a current, preferably the leakage current, when contactable metal parts of electrical devices are tested with a measurement input which is, for protection from dangerous error voltages, shunted by threshold value elements, preferably two diodes, (V3, V4), which are connected antiparallel to one another, in connection with at least one further current limiting element (R1, S1) which is located in series, which limits the current input (I) in the case of a fault, and with a shunt (R5) which is connected in series with the current limiting element and on which there is generated a voltage drop which corresponds to the input current, which voltage drop is delivered to the input (C, D) of a measurement device (M) as a measurement signal, characterised in that a current branch (V1, V2, R3, R4) is formed, which shunts the current limiting element (R1, S1) and which is moved into a conducting state by at least one limiting value element (V1, V2) as soon as, in the case of a fault, the current limiting element (R1, S1) responds, and a voltage corresponding to the limit value of the limit value element (V1, V2) is applied to it, and which then generates, in the current (IZ) flowing in the current branch (V1, V2, R3, R4), a voltage drop which drops at a second shunt (R4) and is delivered to the input (C, D) of the measurement device (M), and that the signal then applied to the input (C, D) is greater than the measurement signal which is normally generated at the first shunt (R5) and which corresponds to the final value of the measurement area.

2. Measurement circuit according to Claim 1, characterised in that the second shunt (R4) forms, together with the first shunt (R5), a series connection located at the input of the measurement device (M).

3. Measurement circuit according to any one of the preceding claims, characterised in that two Zener diodes (V1, V2), connected to one another with opposite poling, act as the limit value element, which Zener diodes form, together with a preresistance (R3) which is connected in series and the second shunt (R4), the current branch (V1, V2, R3, R4).

4. Measurement circuit according to any one of the preceding claims, characterised in that a supplementing resistance (R2) is connected in the measurement circuit between the current limiting element (R1, S1) and the first shunt.

5. Measurement circuit according to any one of the preceding claims, characterised in that a melting fuse (S1) acts as the current limiting element.

6. Measurement circuit according to any one of the preceding claims, characterised in that a PTC resistor (R1) acts as the current limiting element.

7. Measurement circuit according to any one of the preceding claims, characterised in that the resistance of the second shunt (R4) is substantially greater than the resistance of the first shunt (R5), preferably by a factor of from 10 to 20.

## Revendications

1. Montage de mesure pour la détection d'un courant, avantageusement d'un courant de fuite lors de la vérification de parties métalliques susceptibles d'être touchées d'appareils électriques, comportant une entrée de mesure, qui est shuntée, pour une protection contre des tensions de défaut dangereuses, par des éléments de seuil, avantageusement deux diodes (V3, V4) branchées en antiparallèle, en liaison avec au moins un autre élément (R1, S1) de limitation de courant, se trouvant en série, qui limite le courant d'entrée en cas de défaut, et comportant un shunt (R5) branché en série avec l'élément de limitation de courant, shunt sur lequel est produite une chute de tension correspondant au courant d'entrée, et qui est fournie en tant que signal de mesure à l'entrée (C, D) d'un dispositif de mesure (M), caractérisé par le fait qu'une branche latérale de courant (V1, V2, R3, R4), shuntant l'élément de limitation de courant (R1, S1) est réalisée, laquelle branche est placée dans un état conducteur par au moins un élément de valeur limite (V1, V2), dès que, en cas de défaut, l'élément de limitation de courant (R1, S1) réagit et lui applique une tension correspondant à la limite de l'élément de valeur limite (V1, V2), et par le fait que le courant (I2) circulant dans la branche latérale de courant (V1, V2, R3, R4) produit une chute de tension, se formant sur un deuxième shunt (R4) et fournie à l'entrée (C, D) du dispositif de mesure (M), et le signal se trouvant maintenant à l'entrée (C, D) est plus grand que le signal de mesure produit dans un cas normal sur le premier shunt (R5), correspondant à la valeur d'extrémité de zone de mesure.

2. Montage de mesure selon la revendication 1, caractérisé par le fait que le deuxième shunt (R4) forme avec le premier shunt (R5) un couplage série se trouvant à l'entrée du dispositif de mesure (M).

3. Montage de mesure selon l'une des revendications précédentes, caractérisé par le fait que deux diodes Zener (V1, V2) montées en opposition servent d'élément de valeur limite, lesquelles diodes Zener forment avec une résistance (R3) branchée en série et avec le deuxième shunt (R4) la branche latérale de courant (V1, V2, R3, R4).

4. Montage de mesure selon l'une des revendications précédentes, caractérisé par le fait qu'une résistance supplémentaire (R2) est montée dans le circuit de courant de mesure entre l'élément de limitation de courant (R1, S1) et le premier shunt.

5. Montage de mesure selon l'une des revendications précédentes, caractérisé par le fait qu'un fusible (S1) sert d'élément de limitation de courant.

6. Montage de mesure selon l'une des revendications précédentes caractérisé par le fait qu'une résistance à coefficient positif de température (R1) sert d'élément de limitation de courant.

7. Montage de mesure selon l'une des revendications précédentes, caractérisé par le fait que la valeur ohmique de résistance du deuxième shunt (R4) est dimensionnée essentiellement plus forte que la valeur de résistance du premier shunt, avantageusement supérieure d'un facteur 10 à 20.
